# EUROPEAN PATENT SPECIFICATION

(11) **EP 1 246 455 B1**
(45) Date of publication and mention of the grant of the patent: **22.02.2006**
(21) Application number: 02006375.6
(22) Date of filing: 21.03.2002
(51) Int. Cl.: H04N 5/225

(54) **Imaging device**
Bildaufnahmevorrichtung
Dispositif d'imagerie

(30) Priority: 30.03.2001 JP 2001098799
(43) Date of publication of application: 02.10.2002
(73) Proprietor: MITSUBISHI DENKI KABUSHIKI KAISHA, Tokyo 100-8310 (JP)
(72) Inventor: Miyake, Hiroyuki, c/o Mitsubishi Denki K.K., Tokyo 100-8310 (JP); Komori, Noriyuki, c/o Mitsubishi Denki K.K., Tokyo 100-8310 (JP); Shirase, Takashi, c/o Mitsubishi Denki K.K., Tokyo 100-8310 (JP); Hiroe, Ryujiro, c/o Mitsubishi Electric, Chiyoda-ku, Tokyo 100-0004 (JP)
(74) Representative: Bohnenberger, Johannes

(56) References cited:
- EP-A- 0 541 449
- EP-A- 0 860 990
- EP-A- 1 246 456
- US-A- 4 803 557
- US-A- 5 739 853

## Description

### Background of the Invention

### 1. Technical Field

The present invention relates to an imaging device for use in electronic apparatus such as cellular phones, hand-held terminals, personal computers, video cameras, scanners, etc.

### 2. Background Art

Imaging devices are widely used in hand-held terminals of cellular phones and the like under the background of recent progress of communication technology. These imaging devices are increasingly demanded to be more small-sized, and various technological developments have been attempted for small sizing.

For example, the Japanese Patent Publication (unexamined) No. 191864/1999 discloses a solid-state imaging device. In this solid-state imaging device, a CCD (charge coupled device) chip is mounted on one side of a circuit board (substrate) provided with conductive printed wiring, an opening is formed on the circuit board at a place facing an effective picture element region of the CCD chip, and an imaging plane of the CCD chip is located in such a manner as to face the opening formed on the circuit board.

The mentioned Japanese Patent Publication also discloses that the opening on the circuit board is directed toward an imaging lens in order to shorten the distance between the imaging lens and the CCD chip.

In the mentioned conventional imaging device, it is certainly possible to shorten the distance between the imaging lens and the CCD chip, thereby small-sizing the imaging device in that direction. However, the conventional imaging device has a problem. That is, if the CCD chip is not positioned accurately with respect to the imaging lens, an effective image circle of the imaging lens gets out of the effective picture element region of the CCD chip. Consequently, a higher portion of the image, i.e., an outermost portion of the image is not formed on the effective picture element region of the CCD chip, and it is not possible to obtain a good image.

Particularly in the case of using a sheet circuit board (a film-like circuit board) such as FPC (flexible printed circuit), it is very difficult to secure the desired positioning accuracy described above because the circuit board itself is thin and soft.

US5739853 discloses a device for supporting the optical system of a TV camera. The supporting device is provided with legs forming an opening for accommodating the imaging element.

### Summary of the Invention

The present invention has been made to solve the above-discussed problem and has an object of providing a novel imaging device in which positioning accuracy of an imaging element with respect to an imaging lens can be secured just by forming a frame surrounding the imaging element on a leg of the imaging lens, thereby obtaining a good image, and small-sizing of the imaging device is also achieved.

An imaging device according to the invention is set out in claim 1.

As a result, it is possible to accurately mount the imaging element on the opening surrounded with the legs, small size the imaging device, and achieve automatic assembling of the imaging device.

In the mentioned imaging device according to the invention, it is preferable that the film-like circuit board is fixed to the legs with an adhesive at the second cutout part.

In the mentioned imaging device according to the invention, it is preferable that a reinforcing member is mounted on the periphery of the hole of the film-like circuit board. As a result, it is possible to prevent the circuit board from being cut due to stress such as external force.

In the mentioned imaging device according to the invention, it is preferable that an adhesive is applied to the periphery of the through hole of the film-like circuit board and the mentioned film-like circuit board is fixed to the supporting member forming the legs with the mentioned adhesive. As a result, the film-like circuit board is strongly fixed to the supporting member over a large area.

In the mentioned imaging device according to the invention, it is preferable that ribs extending toward the lens-barrel are integrally formed with the legs. As a result, strength of the opening comprised of the supporting member including the legs is increased.

In the mentioned imaging device according to the invention, it is preferable that the film-like circuit board is bent in the opening, a peripheral circuit element mounted on the mentioned film-like circuit board is arranged facing an opposite side of the light acceptance plane of the imaging element, and the mentioned peripheral circuit element is accommodated in the mentioned opening. As a result, it is possible to further small size and simplify the device.

In the mentioned imaging device according to the invention, it is preferable that the opening is sealed with a sealing member. As a result, it is possible to improve reliability in preventing moisture absorption, etc., and prevent the imaging element and the peripheral circuit element from breaking due to external force or the like.

In the mentioned imaging device according to the invention it is preferable that portions coming into contact with a holder serving as fixing means at the time of mounting the imaging device on an electronic equipment are located at four corners of the supporting member. As a result, when the holder is mounted on the body of the imaging device formed by assembling the imaging element, the frame, the circuit board, the supporting member, and so on, it is possible to prevent generation of stress due to load of mounting the holder. Thus, it is possible to prevent occurrence of any trouble caused by, for example, peeling of the circuit board from the imaging element.

### Brief Description of the Drawings

Fig. 1 is a perspective view showing an imaging device according to Embodiment 1 of the present invention.
Figs. 2 (a), (b) and (c) are flow sheets showing a series of flow for constructing the imaging device according to Embodiment 1 of the invention.
Fig. 3 is a perspective view similar to Fig. 1 in which a line I - I is added.
Fig. 4 is a sectional view of the imaging device taken along the line I - I in Fig. 3.
Fig. 5 is a perspective view showing an imaging device according to Embodiment 2 of the invention.
Fig. 6 is an exploded perspective view showing the imaging device according to Embodiment 2 of the invention.
Fig. 7 is a perspective view similar to Fig. 5 in which a line II- II is added.
Fig. 8 is a sectional view of the imaging device taken along the line II-II in Fig. 7.
Fig. 9 is a perspective view showing an imaging device according to Embodiment 3 of the invention.
Fig. 10 is an exploded perspective view showing the imaging device according to Embodiment 3 of the invention.
Fig. 11 is a perspective view showing a construction of a supporting member of an imaging device according to Embodiment 4 of the invention.
Fig. 12 is a perspective view showing a modification of the supporting member of the imaging device according to Embodiment 4 of the invention.
Fig. 13 is a schematic perspective view showing a state of applying a liquid fixing member in an imaging device according to Embodiment 5 of the invention.
Fig. 14 is a schematic perspectiveview showing state of applying a film-like fixing member in the imaging device according to Embodiment 5 of the invention.
Fig. 15 is an exploded perspective view showing the imaging device according to Embodiment 5 of the invention in which a line III-III added.
Fig. 16 is a sectional view of the imaging device taken along the line III-III in Fig. 15.
Fig. 17 is a sectional view showing an opening of the imaging device shown in Fig. 16 sealed with a sealing member.
Fig. 18 is a sectional view showing a construction of an imaging device according to Embodiment 6 of the invention.
Fig. 19 is a sectional view showing an opening of the imaging device shown in Fig. 18 sealed with a sealing member.
Fig. 20 is a perspective view showing an imaging device according to Embodiment 7 of the invention.
Fig. 21 is an exploded perspective view showing the imaging device according to Embodiment 7 of the invention.
Fig. 22 (a) and (b) are flow sheets showing a flow for constructing the imaging device shown in Fig. 21.
Fig. 23 is an exploded perspective view showing the imaging device according to Embodiment 8 of the invention in which a line IV-IV is added.
Fig. 24 is a sectional view of the imaging device taken along the line N-N in Fig. 23.
Fig. 25 is a sectional view for explaining the imaging device according to Embodiment 8 of the invention.
Fig. 26 is a perspective view showing the imaging device according to Embodiment 8 of the invention.

### Description of the Preferred Embodiments

Several preferred embodiments of the invention are hereinafter described with reference to the accompanying drawings. In the drawings, the same reference numerals are designated to the same or like parts.

### Embodiment 1.

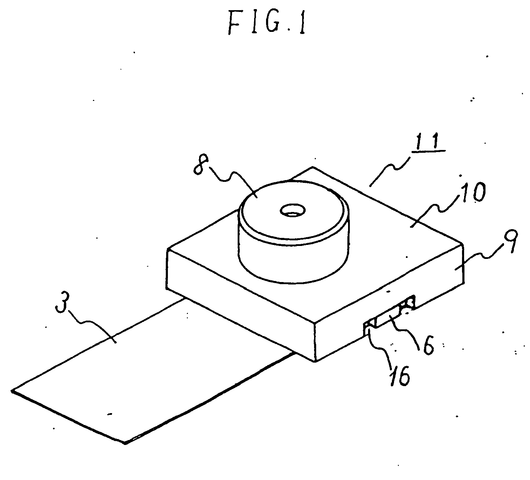

Embodiment 1 of the invention is hereinafter described with reference to Figs. 1 to 4.

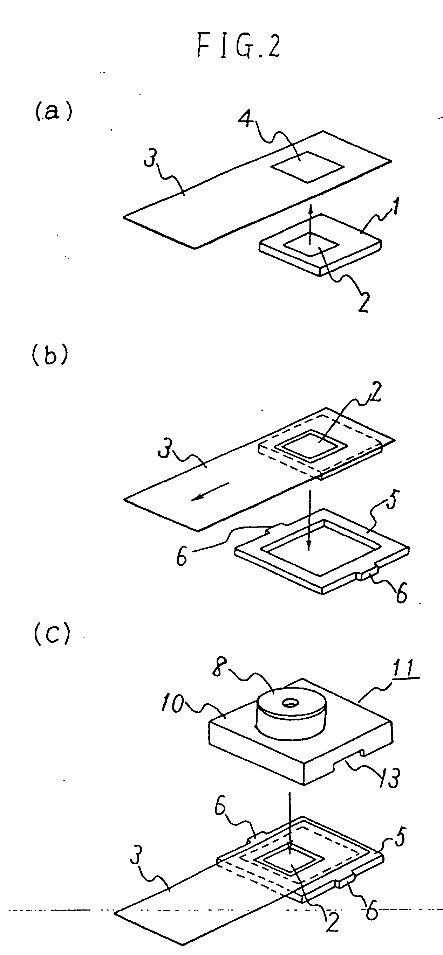

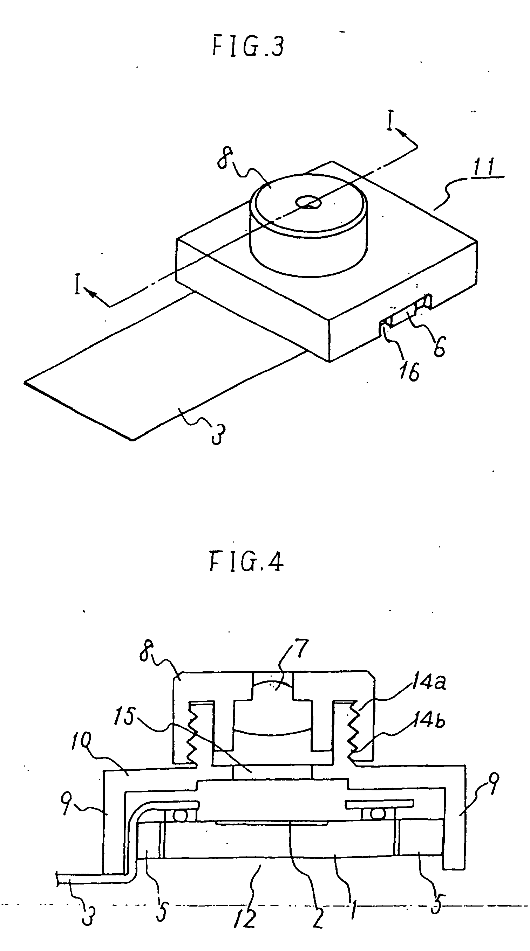

Fig. 1 is a perspective view showing an imaging device according to Embodiment 1 of the invention, and Figs. 2 (a) to (c) are flow sheets showing a series of flow for constructing the imaging device according to Embodiment 1. Fig. 3 is a perspective view similar to Fig. 1 and in which a line I- I is added, and Fig. 4 is a sectional view of the imaging device taken along the line I-I in Fig. 3.

In Figs. 1 to 4, reference numeral 1 is an imaging element such as CCD chip. Numeral 2 is an imaging plane (it is also referred to as a light acceptance plane) of the imaging element 1. Numeral 3 is a film-like circuit board (hereinafter simply referred to as "the circuit board") composed of FPC or the like, and a through hole 4 where the imaging plane 2 is exposed is formed near the end of the circuit board 3. Wiring pattern not shown is formed on one face or both faces of the circuit board 3.

As shown in Fig. 2 (b), the imaging element 1 is fixed to the backside of the circuit board so that the imaging plane 2 may correspond to the through hole 4 and be exposed from an upper portion of the circuit board 3. Numeral 5 is a frame surrounding the imaging element 1, and the frame 5 is fixed to the imaging element 1 so as to surround' peripheral side of the imaging element 1 as shown in Fig. 2(c).

Numeral 6, 6 are protrusions, and the protrusions 6, 6 are integrally formed with the frame 5. The protrusions 6, 6 are formed on the sides in the direction of width of the circuit board 3 and protrude respectively in the direction perpendicularly crossing the extending direction of the circuit board 3 indicated by the arrow in Fig. 2(c). Numeral 7 is an imaging lens (also referred to as image formation lens), and the imaging lens 7 forms an image on the imaging plane 2 through the hole 4 of the circuit board 3. Numeral 8 is a lens-barrel for holding the imaging lens 7, numeral 9 is a leg portion, and numeral 10 is a supporting portion for connecting the lens-barrel 8 with the leg 9. The lens-barrel 8, the leg 9 and the supporting portion 10 form a supporting member 11.

As shown in Fig. 2(c), the leg 9 is provided with recesses (cutout parts) 13, 13 where the protrusions 6, 6 are inserted and fitted. Fig. 3 shows the protrusions 6, 6 of the frame 5 fitted in the recess 13, 13 of the leg 9.

As shown in Fig. 4, the leg 9 and the supporting portion 10 form an opening 12 which is a box-shaped space, and the imaging element 1 and the circuit board 3 combined with the frame 5 are inserted in this opening 12.

The mentioned frame 5 and the supporting member 11 can be formed with high dimensional accuracy by injection molding of ABS resin or the like. In the form of such molding, the protrusions 6, 6 of the frame 5, the recess (cutout part) 13, 13 of the leg 9, and later-described focal distance adjusting means composed of the lens-barrel 8 and the supporting portion 10 can be easily formed.

The imaging lens 7 held by the lens-barrel 8 and the imaging element 1 can be easily positioned by fitting the protrusions 6, 6 of the frame 5 formed with high dimensional accuracy into the recess 13, 13 of the leg 9. Consequently, an image is correctly formed on the imaging plane 2 of the imaging element 1 through the imaging lens 7.

As shown in Fig. 4, a screw groove is formed inside the lens-barrel 8, and another screw groove that fits with this screw groove is formed on the supporting portion 10 (hereinafter referred to as screw-fitting means 14a). Furthermore, the lens-barrel 8 is provided with a guide portion 14b inside the screw fitting means 14a forming a double structure.

By means of this screw fitting means 14a, the lens-barrel 8 is constructed such that the focal distance in the direction of height of the imaging lens 7 with respect to the imaging plane 2 is adjustable. Further by combining, fitting and assembling the guide portion 14b and the supporting portion 10 together, the relative position between an optical axis of the image formation lens 7 and the imaging plane 2 is established within a predetermined tolerance.

In addition, the supporting portion 10 is provided with a hole 15 for passing a light to form an image through the imaging lens 7 above the imaging plane 2. In the case of holding the protrusions 6, 6 of the frame 5 and the recesses 13, 13 of the leg 9 by inserting and fitting the protrusions 6, 6 in the recesses 13, 13 respectively, strict dimensional tolerance is required. It is preferable to expand the allowable range of this tolerance and fix the protrusions 6 of the frame 5 to the recesses 13, 13 of the leg 9 by fixing means 16 such as adhesive. This "fitting" is a broad concept including both of these arrangements.

### Embodiment 2.

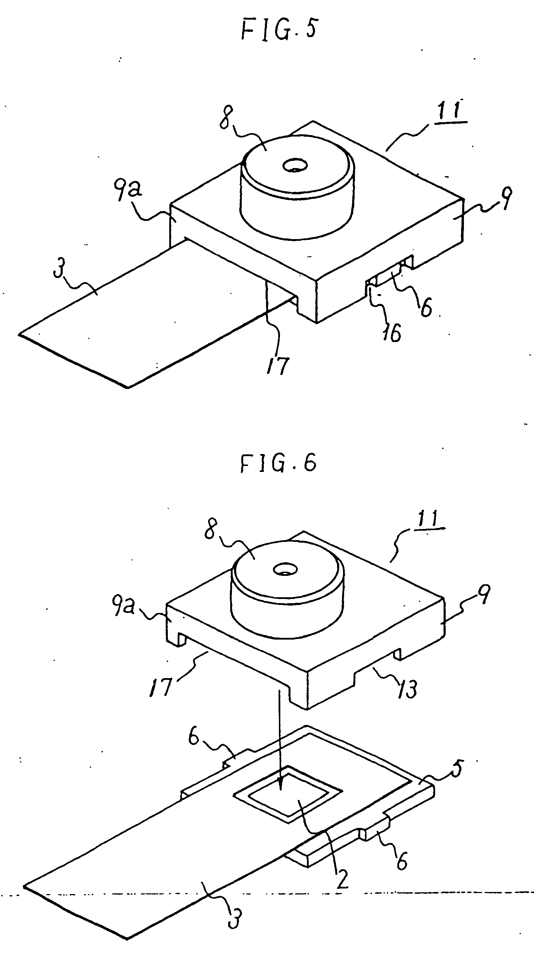

Now, Embodiment 2 of the invention is described with reference to Figs. 5 to 8.

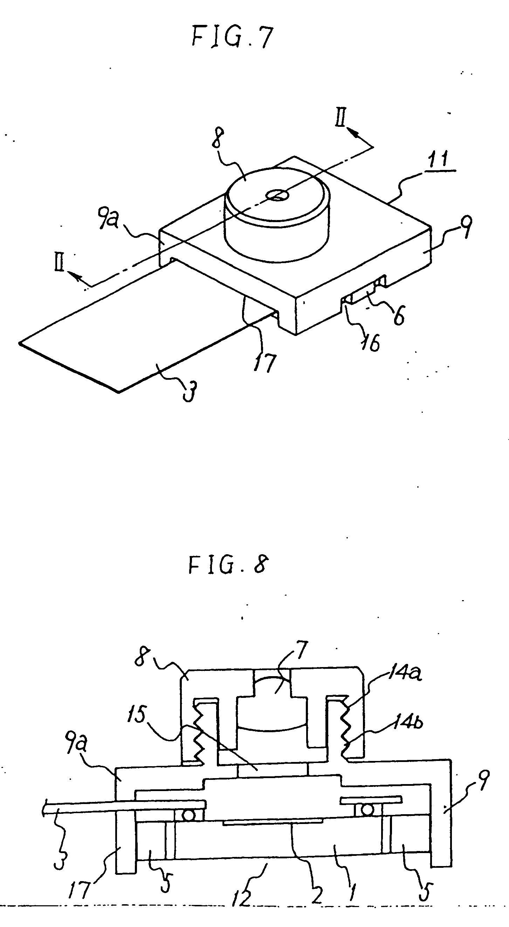

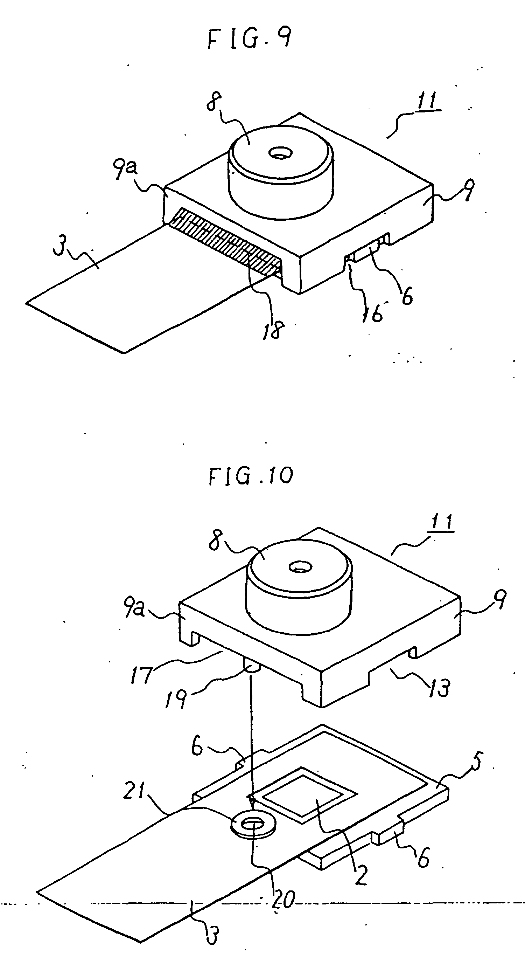

Fig. 5 is a perspective view showing an imaging device according to Embodiment 2, and Fig. 6 is an exploded perspective view of the imaging device according to Embodiment 2. Fig. 7 is a perspective view similar to Fig. 5 in which a line II-II is added, and Fig. 8 is a sectional view of the imaging device taken along the line II-II in Fig. 7.

In Figs. 5 to 8, numeral 17 is a recess (cutout part) formed on the leg 9a in the extending direction of the circuit board 3. Width of the recess 17 corresponds to the width of the circuit board 3 drawn out of the opening 12.

As shown in Fig. 7, the circuit board 3 is drawn out of the opening 12 formed by the leg 9 and the leg 9a through the recess 17. Unlike the case shown in Fig. 3, in this construction, the circuit board 3 can be taken cut without bending.

As a result, it is possible to prevent the film-like circuit board 3 from being damaged due to bending and improve reliability of the device.

In the drawings showing Embodiment 2, the same reference numerals as those in Figs. 1 to 4 showing Embodiment 1 are designated to the same or like parts, and explanation thereof is omitted herein.

### Embodiment 3.

Now, Embodiment 3 of the invention is hereinafter described with reference to Figs. 9 and 10.

Fig. 9 is a perspective view showing an example of an imaging device according to Embodiment 3, and Fig. 10 is an exploded perspective view showing the imaging device according to Embodiment 3. In Fig. 9, numeral 18 is fixing means such as adhesive for fixing the leg 9a to the circuit board 3 drawn out of in the recess 17 (cutout part) of the leg 9a. The leg 9a is fixed to the circuit board 3 with this fixing means 18.

The fixing means 18 is, for example, an ultraviolet curing type resin.

In Fig. 10, numeral 19 is a projection that is provided on the leg 9a and projects downward. Numeral 20 is a hole provided through the circuit board 3, and the projection 19 is inserted into the hole 20 in order to approximately position the circuit board 3 with which the imaging element 1 and the frame 5 are integrally combined and the supporting member 11.

In other words, by inserting the projection 19 formed on the leg 9a in the hole 20 provided through the circuit board 3, the lens-barrel holding the imaging lens 7 is mounted. At the same time, the supporting member 11 forming the leg 9 and the circuit board 3 can be approximately positioned with ease.

Numeral 21 is a reinforcing member mounted on the periphery of the hole 20 for the purpose of reinforcing the circuit board 3. In the case that the circuit board 3 is a soft circuit board such as film-like circuit board, after inserting the projection 19, the reinforcing member 21 prevents the circuit board from being cut due to stress such as external force.

### Embodiment 4.

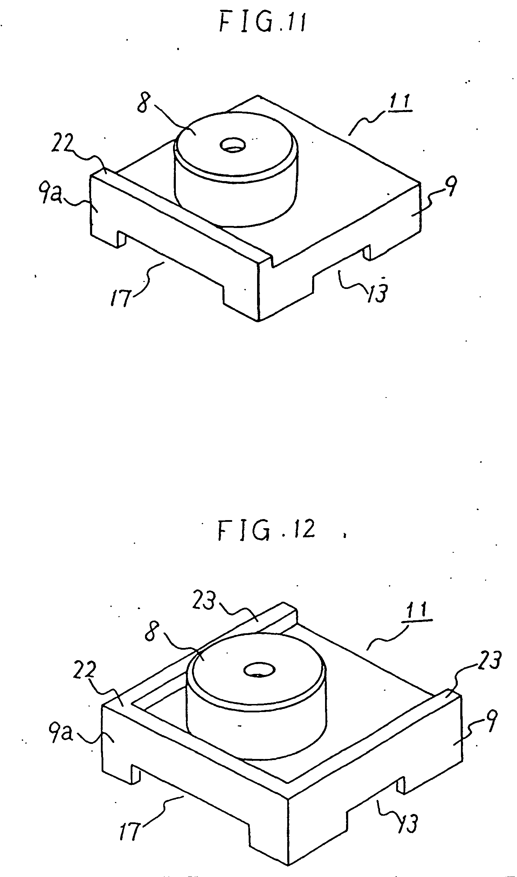

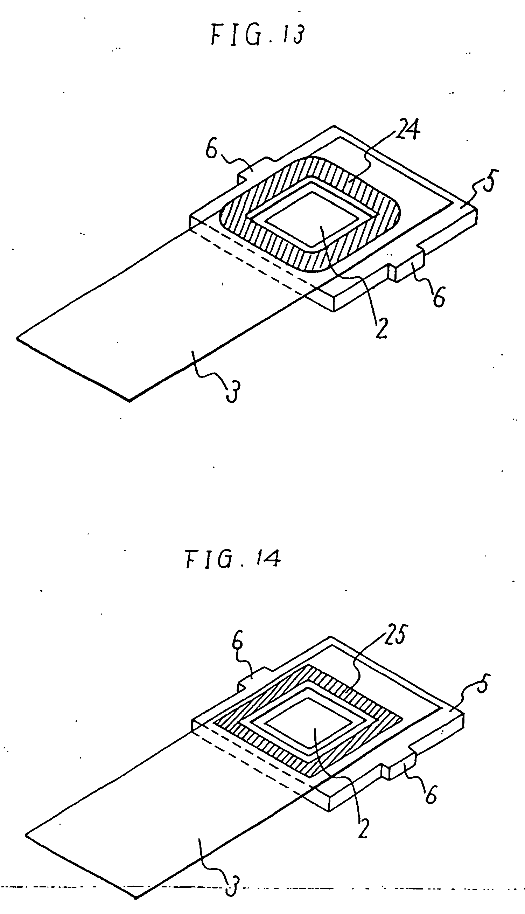

Now, Embodiment 4 of the invention is hereinafter described with reference to Figs. 11 and 12.

In the imaging device according to the foregoing Embodiment 2, the leg 9 of the supporting member 11 is provided with the recesses 13 being the first cutout part, and the leg 9a is provided with the recess 17 being the second cutout part, respectively. As a result, there is a disadvantage in that the supporting member 11 forming the opening 12 is deteriorated in structural strength due to the cutout parts formed on the legs 9 and 9a.

The imaging device according to this Embodiment 4 is intended to improve the structural strength of the portion of the supporting member 11 where the cutout parts and the like are formed.

Fig. 11 is a perspective view showing an example of the imaging device according to Embodiment 4, and Fig. 12 is a perspective view showing a modification of the imaging device according to Embodiment 4. In Figs. 11 and 12, numeral 22 is a rib continuously extending upward from the supporting portion 10 on the leg 9a, and numeral 23 is a rib continuously extending upward from the supporting portion 10 on the leg 9. Forming these reinforcing ribs 22 and 23 reinforces the legs 9 and 9a.

The imaging element 1, the circuit board 3, the frame and so on are constructed in the same manner as those in the imaging devices according to the foregoing embodiments. The frame 5, the circuit board 3 and so on are not illustrated in the description of the imaging device according to this embodiment.

### Embodiment 5.

Now, Embodiment 5 of the invention is hereinafter described with reference to Figs. 13 to 16. In the imaging device according to the foregoing Embodiment 3, the circuit board 3 is fixed to the leg 9a with the fixing means such as the adhesive 18. However, the device itself is small-sized in such an imaging device, and such fixing is not always sufficient to maintain the fixed situation when a strong impact is applied from outside.

This embodiment is intended to firmly fix the circuit board 3 to the supporting member 11.

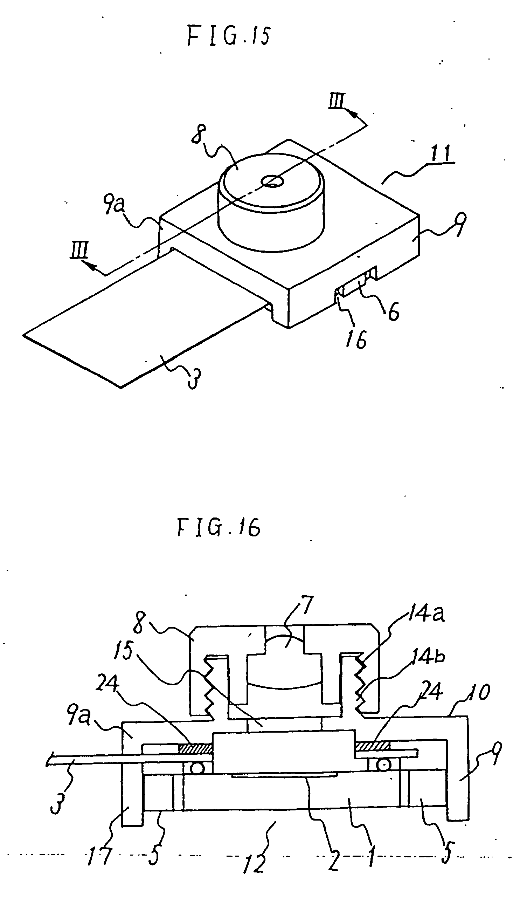

Figs. 13 and 14 are schematic perspective views each showing an imaging device before mounting the supporting member 11 on the circuit board 3. Fig. 15 is a perspective view showing the imaging device according to Embodiment 5 in which a line III-III is added, and Fig. 16 is a sectional view of the imaging device taken along the line III-III in Fig. 15.

In Figs. 13 to 16, numerals 24 and 25 are fixing members (adhesive) applied to the through hole 4 of the circuit board 3 and to the periphery of the imaging plane 2 of the imaging element 1 exposed at this through hole 4. Numeral 24 is an adhesive liquid fixing member and numeral 25 is a film-like fixing member that is adhesive as well as the fixing member 24. The fixing member 24 is illustrated in the sectional view of the imaging device shown in Fig. 16. In the drawings, the same numerals are designated to the same or like parts, and detailed explanation thereof is omitted herein.

In the imaging device according to this Embodiment 5, as shown in Figs. 13 or 14, the fixing member 24 or 25 is applied to the periphery of the through hole 4 of the circuit board 3. Thus, the circuit board 3 is fixed to the supporting member 11 through this fixing member 24 or 25. Consequently, a wide fixed area is secured between the circuit board 3 and the supporting member 11, and the circuit board 3 is firmly fixed to the supporting member 11. As shown in Fig. 16, the circuit board 3 accommodated in the opening 12 of the supporting member 11 is fixed to the supporting member 11 with a sealing member 24.

In this manner, it is possible to prevent the circuit board 3 from peeling off the supporting member 11 even if the imaging device is used under the condition that any impact is applied from outside due to dropping or the like. The imaging element 1 can be kept at the focal position of the imaging lens 7 where the imaging element 1 is positioned, and eventually it becomes possible to obtain an imaging device of high quality with a desired reading accuracy assured.

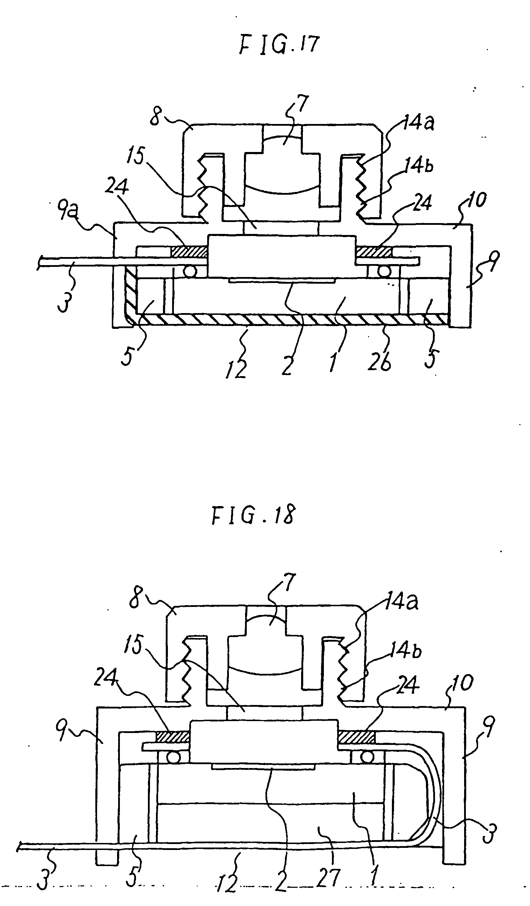

Fig. 17 is a sectional view showing the opening 12 of the imaging device according to this embodiment sealed with a sealing member. As shown in Fig. 17, the opening 12, in which the imaging element 1, the frame 5, and the circuit board 3 are inserted, is sealed with the sealing member 26. As a result, reliability in preventing moisture absorption is improved, and the backside of the imaging element 1 is not directly exposed looking from the opening 12 side. Consequently, it is possible to prevent the imaging element from being damaged by external force or the like.

### Embodiment 6.

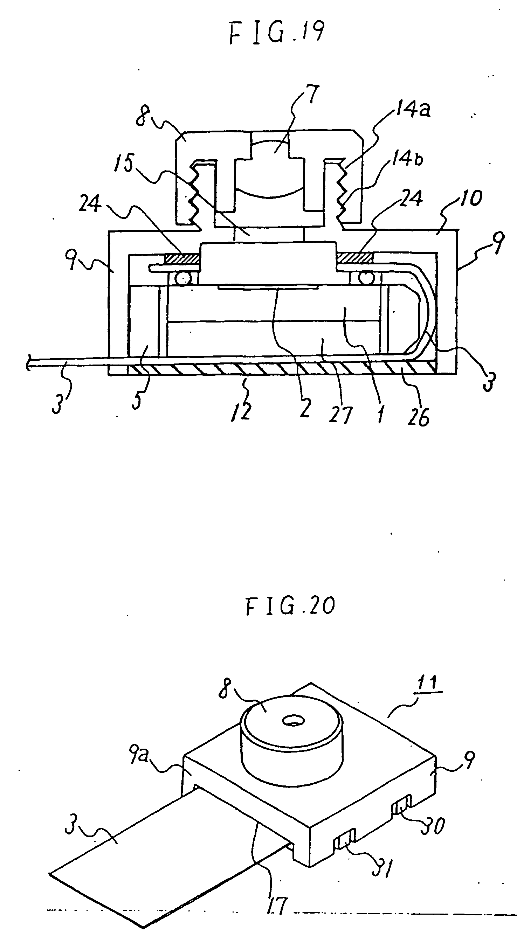

Now, Embodiment 6 is hereinafter described with reference to Figs. 18 and 19. In the imaging device according to this embodiment, the circuit board 3 provided with the imaging element 1 and a peripheral circuit element 27 is bent in such a manner that the imaging element 1 and the peripheral circuit element may lie one upon another. Thus, the imaging element 1 and the peripheral circuit element are accommodated in the opening 12 of the supporting member 11.

The peripheral circuit element 27 is, for example, an image signal processing IC for optimizing imaging conditions on the basis of the signal outputted from the imaging element 1.

Fig. 18 is a sectional view showing a construction of an imaging device according to this Embodiment 6, and Fig. 19 is a sectional view showing an opening of the imaging device shown in Fig. 18 sealed with a sealing member.

In Figs. 18 and 19, numeral 27 is a peripheral circuit element, and the peripheral circuit element 27 and the imaging element 1 lie one upon another. Numeral 3 is a film-like circuit board bent in the opening 12 of the supporting member 11 so that the imaging element 1 and the peripheral circuit element 27 may lie one upon another. Numeral 26 is a sealing member for sealing the opening 12 of the supporting member 11 in which the imaging element 1, the peripheral circuit element 27, and the circuit board 3 are accommodated.

As shown in Figs. 18 and 19, in the imaging device according to this embodiment, the circuit board 3 is bent, and the imaging element 1 and the peripheral circuit element 27 are accommodated in the opening 12 of the supporting member 11.

Accordingly, it is no longer necessary to arrange them in any region on the circuit board 3 drawn out of the opening 12 of the supporting member 11. It is also unnecessary to arrange them, separately from the imaging device, on the circuit board on the body side of the electronic equipment where the imaging device is mounted. As a result, it is possible to small size and simplify the construction of the imaging device.

Furthermore, the opening 12 of the supporting member 11, in which the imaging element 1, the peripheral circuit element 27 and the circuit board 3 are accommodated, is sealed with the sealing member 26. As a result, it is possible to improve reliability in preventing moisture absorption, and prevent the imaging element and the peripheral circuit element from being damaged by external force or the like.

### Embodiment 7.

Now, Embodiment 7 of the invention is hereinafter described with reference to Figs. 20 to 22.

In the imaging devices according to the foregoing embodiments, one protrusion 6 integrally formed with the frame 5 and one recess 13 of the leg 9 in which the protrusion is inserted and fitted are respectively provided on the opposite side of the frame 5 or the leg 9. On the other hand, in the imaging device according to this embodiment, plural protrusions of the frame 5 for positioning the imaging element 1 and the imaging lens 7and recesses of the leg 9 are provided on the opposite side of the frame 5 or the leg 9. Furthermore, each of those plural protrusions and recesses is small-sized.

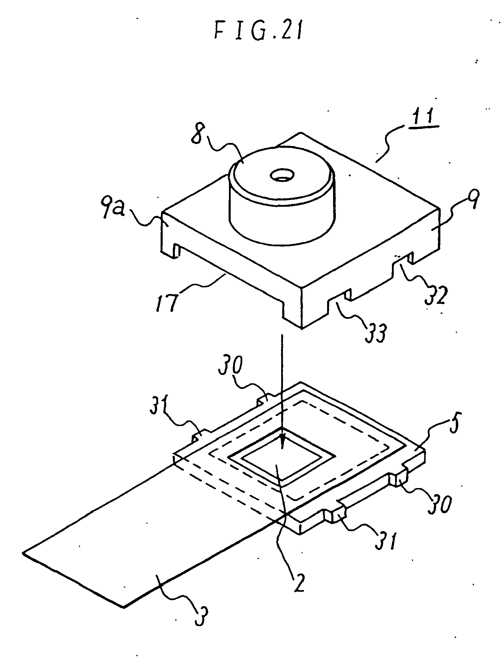

Fig. 20 is a perspective view showing the imaging device according to this embodiment, and Fig. 21 is an exploded perspective view showing the imaging device.

Described in this embodiment is a construction of the imaging device in which each of the opposite sides is provided with two protrusions of the frame 6 or two recesses of the leg 9.

In Figs. 20 and 21, numerals 30 and 31 are protrusions integrally formed on the frame 5, and numerals 32 and 33 are recesses of the leg 9 in which the protrusions 30 and 31 are inserted and fitted respectively. The protrusions 30, 31 are inserted and fitted in the recesses 32, 33, whereby the imaging element 1 surrounded with the frame 5 and the circuit board 3 are accommodated in the opening 12 of the supporting member 11. Accordingly, it is possible to make a positioning between the imaging plane 2 of the imaging element 1 and the image formation position of the imaging lens 7 supported by the lens-barrel 8.

In the imaging device shown in Figs. 20 and 21, the leg 9a among the legs of the supporting member 11 on the side from which the circuit board 3 is drawn out is provided with a recess (cutout part) 17 having the same width as the circuit board 3. Note that this embodiment is also applicable to an imaging device without the recess 17 as shown in Fig. 1.

In the imaging device according to this embodiment, the frame 5 is connected with the supporting member 11 comprised of the lens-barrel 8, the leg 9 and the supporting portion 10. This connection is achieved by inserting and fitting the protrusions 30 and 31 in the recesses 32 and 33, and the connected portions are small-sized as a result of forming the plural protrusions 30 and 31 and plural recesses 32 and 33. Consequently, it is possible to moderate and disperse the reduction in structural strength of the connected portions due to the formation of the cutout parts in the supporting member 11.

Now, a method for manufacturing the imaging device according to this embodiment is hereinafter briefly described.

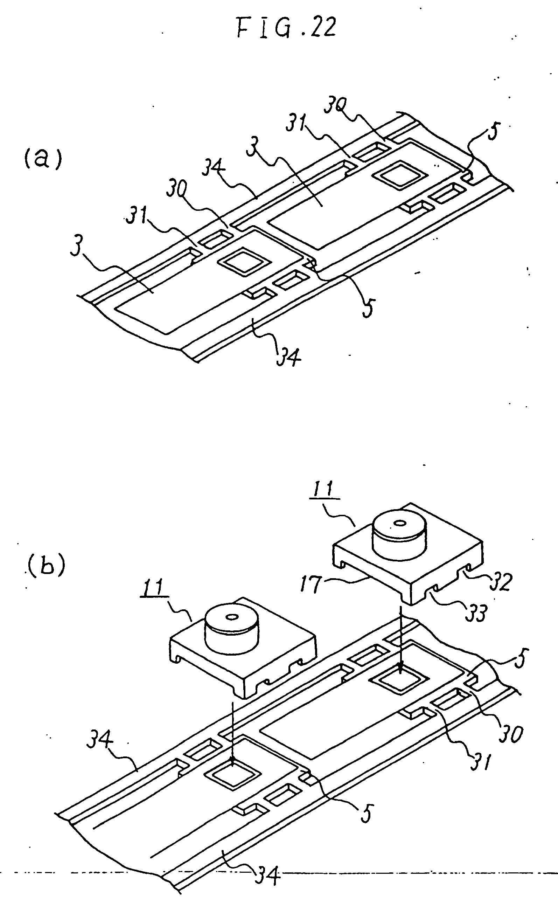

Figs. 22 (a) and (b) are flow sheets showing a series of flow for constructing the imaging device according to this embodiment.

In Fig. 22 (a) and (b), numeral 34 is a lead frame in which plural frames 5 are integrally formed. The lead frame 34 is integrally formed with the frames 5 through the portions of the protrusions 30, 31 of the frames 5. As described above, the frames 5 and the supporting member 11 are molds produced by molding with metallic mold and so on, and the lead frame 34 having the plural frames 5 as shown in Fig. 22 (a) is also formed by molding in the same manner. In this embodiment, such a lead frame 37 is conveyed to manufacture an imaging device.

As shown in Fig. 22 (b), in this embodiment, first the circuit board 3 to which the imaging element 1 is fixed is placed on each frame 5 of the conveyed lead frame 34, then each imaging element 1 is surrounded with the frame 5.

In addition, the frames 5 are spaced from one another in order to prevent the circuit board 3 mounted on the frame 5 from coming into contact with the subsequent circuit board 3 and frame 5.

Then, each supporting member 11 having the imaging lens 7 is placed on the circuit board 3 from above, and the protrusions 30, 31 of the frame 5 are inserted and fitted in the recesses 32, 33 formed on the leg 9 of the supporting member 11.

Fixing means such as adhesive is applied to the portions where the protrusions 30, 31 are inserted and fitted in the recesses 32, 33 when required, in order to firmly fix the supporting members 11 to the frames 5. Thereafter, the frames 5 and the lead frame 34 are separated by disconnecting the lead frame 34 and the protrusions 30, 31, thereby the imaging devices being obtained.

As described above, in the manufacturing method according to this embodiment, the plural frames 5 and the lead frame 34 are connected and integrally formed by molding as shown in Fig. 22(a). It is therefore possible to establish dimensions of the frames 5 and a distance between one frame 5 and another with highly dimensional accuracy.

As a result, it is possible to position each of the frames 5 with ease, and plural imaging devices can be assembled easily and promptly.

Furthermore, each circuit board 3 provided with the imaging element 1 is correctly placed on the frame 5 without difficulty, and it is therefore possible to easily achieve automated mechanical assembling.

In the flow sheet of the imaging device shown in Figs. 22 (a) and (b), one side of the frame 5 and the leg 9 is provided with two protrusions 30, 31 and two recesses 32, 33. The invention is not limited to such a construction as far as the frames are easily and stably disconnected from the lead frame.

### Embodiment 8.

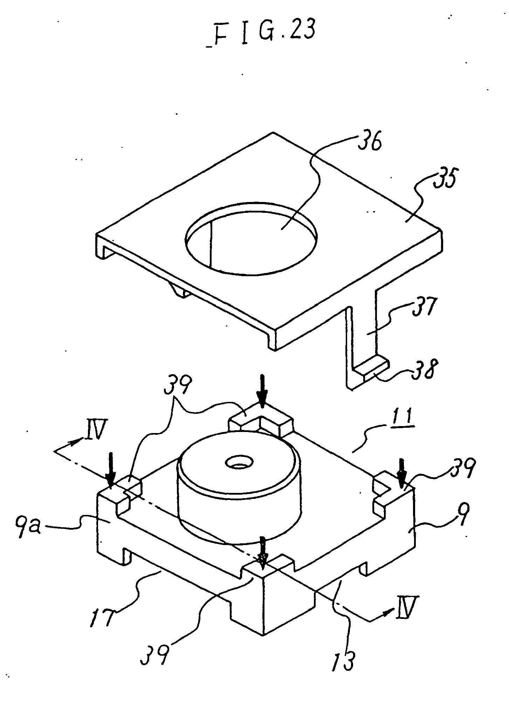

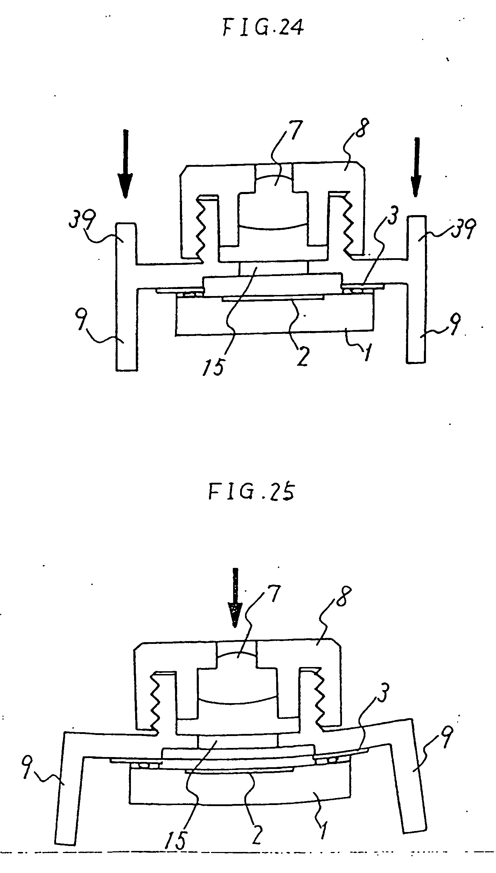

Now, Embodiment 8 of the invention is hereinafter described with reference to Figs. 23 and 24. Fig. 23 showing an imaging device according to this embodiment is an exploded perspective view in which a line N-N is added. Fig. 24 is a sectional view of the imaging device taken along the line IV-IV in Fig. 23.

In Fig. 23, numeral 35 is a holder mounted on the body of the imaging device from above the supporting member 11 supporting the lens-barrel 8. Numeral 36 is a hole provided through the holder 35 and in which the lens-barrel is inserted when the holder 35 is mounted. Numeral 37 is a mounting member used at the time of mounting the holder 35 on the body of the imaging device. Numeral 38 is a key part formed at the end of the mounting member 37, and numeral 39 is a contact portion that is formed at each corner of the support portion 10 forming the supporting member 11 and comes in contact with the holder 35.

As shown in Fig. 23, the holder 35 is provided with the hole 36 through which the lens-barrel 8 is inserted, and therefore each of the contact portions 39 provided at the four corners of the support portion 10 comes in contact with the holder 35. As shown in Fig. 24, the mounting load in the direction of the arrow generated at the time of mounting the holder 35 is applied through the contact portions 39 in the extending direction of the legs 9 and 9a continuous from the supporting portion 10.

In the case of mounting the holder 35 on the body of the imaging device body after assembling the imaging device comprised of the imaging element 1, the circuit board 3, the supporting members 11, and so on, the mounting load is uniformly applied from the lens-barrel 8. And as shown in Fig. 25, the structure of the supporting member 11 is deformed and a stress is generated at the portion where the imaging element 1 is in contact with the circuit board 3 in the direction of peeling the imaging element 1 off the circuit board 3. Generation of such stress causes the imaging element 1 to peel off the circuit board 3 and brings about any trouble or the like.

In the imaging device according to this embodiment, however, the amounting load at the time of mounting the holder 35 is not uniformly applied from the lens-barrel 8 but is applied through the contact portions 39 to the corners of the supporting portion 10 and the legs 9 and 9a. Therefore, in spite of mounting the holder 35, the connecting portion between the imaging element 1 and the circuit board 3 is prevented from generation of stress caused by such mounting load. As a result, it is possible to obtain an imaging device of high quality being prevented from occurrence of any trouble in the device after assembling the imaging element 1, the circuit board 3, the supporting member 11, and so on into the device.

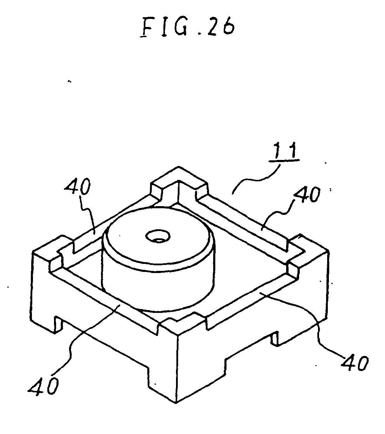

It is also preferable to provide a reinforcement member such as rib between one contact portion 39 and another formed at the corners of the supporting portion 10 for connection between one contact portion 39 and another with the reinforcement member. Fig. 26 is a perspective view showing the imaging device according to this embodiment provided with such reinforcement members.

In Fig. 26, numeral 40 is the rib continuous from the supporting portion 10 and extending upward from the legs 9 or 9a. This rib 40 is the reinforcement member for connecting the contact portions 39 formed at the corners of the supporting portion 10 with each other.

In the drawings, the same reference numerals indicate the same or like parts, and further detailed explanation of them is omitted herein. As shown in Fig. 26, the structure of the supporting member 11 is reinforced as a result of providing the reinforcement members 40 for connecting between one contact portions 39 and another. Consequently, it is possible to prevent generation of stress caused by the mounting load of the holder 35 as described above, and eventually, it is possible to obtain an imaging device of high quality prevented from occurrence of any trouble or the like in the device.

## Claims

1. An imaging device comprising:
- an imaging element (1) having a light acceptance plane (2);
- a frame (5) surrounding the peripheral sides of said imaging element (1) and fixing said imaging element (1);
- an imaging formation lens (7) for forming an image on said light acceptance plane (2);
- a lens barrel (8) for supporting said image formation lens (7); and
- a supporting member (11) in which said lens barrel (8) is mounted and which is provided with legs (9) forming an opening (12) for accommodating said frame (5) and said imaging element (1),
- protrusions (6) formed on the outside of said frame (5) in the direction of its width; and
- recesses (13) defined by cut-away portion of said legs (9) of said supporting member (11) in which said protrusions (6) are inserted and fitted;
**characterized by**
- a film-like circuit board (3) upon which a wiring pattern is formed, in which a through hole (4) is provided for exposing the light acceptance plane (2) of an image element (1),
- the film-like circuit board (3) is positioned on the frame (5) with the through hole (4) aligned with the light acceptance plane (2) of the image element (1) and is contained within the opening (12) of the supporting member (11),
- a second cut-out part (17) is formed in one of the legs (9) of the supporting member (11) which is not accommodating a recess (13), such that the film-like circuit board (3) can extend from the opening (12) through the cut-out (17) without being folded,
- a projection (19) projecting downward from the supporting member (11) toward the film-like circuit board (3) and positioned within the second cut-out (17), and a hole (20) provided on said film-like circuit board (3) in which said projection (19) is inserted.

2. The imaging device according to claim 1, **characterized in that** a reinforcing member (21) is mounted on the periphery of the hole of the film-like circuit board (3).

3. The imaging device according to any of the preceding claims 1 to 2, **characterized in that** an adhesive is applied to the periphery of the through hole (4) of the film-like substrate (3) and said film-like circuit board is fixed to the supporting member (11) forming the legs (9) with said adhesive.

4. The imaging device according to any of the preceding claims 1 to 3 **characterized in that** a rib (22, 23) extending toward the lens-barrel is integrally formed with the legs.

5. The imaging device according to any of the preceding claims 1 to 4, in particular claim 1, **characterized in that** said film-like circuit board (3) is bent in the opening (12), a peripheral circuit element (27) mounted on said film-like circuit board (3) is arranged facing an opposite side of the light acceptance plane (2) of the imaging element (1), and said peripheral circuit element (27) is accommodated in said opening (12).

6. The imaging device according to any of the preceding claims 1 to 5, **characterized in that** the opening (12) is sealed with a sealing member (26).

7. The imaging device according to any of the preceding claims 1 to 6, **characterized in that** portions (39) coming into contact with a holder (35) serving a fixing means at the time of mounting the imaging device on an electronic equipment are located at four corners of the supporting member (11).

## Patentansprüche

1. Abbildungsvorrichtung, die Folgendes aufweist:
- ein Abbildungselement (1), das eine Lichtaufnahmeebene (2) hat;
- einen Rahmen (5), der die Außenumfangsseiten des Abbildungselements (1) umgibt und das Abbildungselement (1) fixiert;
- ein Bilderzeugungsobjektiv (7), um auf der Lichtaufnahmeebene (2) ein Bild zu erzeugen;
- einen Objektivtubus (8), um das Bilderzeugungsobjektiv (7) abzustützen;
- ein Stützelement (11), in dem der Objektivtubus (8) angebracht ist und das mit Schenkeln (9) versehen ist, die eine Öffnung zur Aufnahme des Rahmens (5) und des Abbildungselements (1) bilden,
- Vorsprünge (6), die an der Außenseite des Rahmens (5) in seiner Breitenrichtung ausgebildet sind; und
- Aussparungen (13), die von einem ausgeschnittenen Bereich der Schenkel (9) des Stützelements (11) definiert sind und in welche die Vorsprünge (6) eingesetzt und eingepasst sind;
**gekennzeichnet durch**
- eine schichtartige Leiterplatte (3), auf der eine Leiterstruktur ausgebildet ist, in der ein Durchgangsloch (4) vorgesehen ist, um die Lichtaufnahmeebene (2) eines Abbildungselements (1) zu belichten,
- wobei die schichtartige Leiterplattte (3) auf dem Rahmen (5) positioniert ist, wobei das Durchgangsloch (4) mit der Lichtaufnahmeebene (2) des Abbildungselements (1) ausgefluchtet und in der Öffnung (12) des Stützelements (11) enthalten ist,
- wobei ein zweiter ausgeschnittener Teil (17) in einem der Schenkel (9) des Stützelements (11) gebildet ist, der keine Aussparung (13) aufweist, so dass sich die schichtartige Leiterplatte (3) von der Öffnung (12) **durch** den Ausschnitt (17) erstrecken kann, ohne gefaltet zu werden,
- einen Vorsprung (19), der von dem Stützelement (11) nach unten in Richtung zu der schichtartigen Leiterplatte (3) vorsteht und in dem zweiten Ausschnitt (17) positioniert ist, und ein an der schichtartigen Leiterplatte (3) vorgesehenes Loch (20), in das der Vorsprung (19) eingesetzt ist.

2. Abbildungsvorrichtung nach Anspruch 1, **dadurch gekennzeichnet, dass** ein Verstärkungselement (21) an dem Rand des Lochs der schichtartigen Leiterplatte (3) angebracht ist.

3. Abbildungsvorrichtung nach einem der vorhergehenden Ansprüche 1 oder 2, **dadurch gekennzeichnet, dass** ein Klebstoff auf dem Rand des Durchgangslochs (4) des schichtartigen Substrats (3) aufgebracht ist und die schichtartige Leiterplatte an dem die Schenkel (9) bildenden Stützelement (11) mit dem Klebstoff fixiert ist.

4. Abbildungsvorrichtung nach einem der vorhergehenden Ansprüche 1 bis 3, **dadurch gekennzeichnet, dass** eine sich in Richtung zu dem Objektivtubus erstreckende Rippe (22, 23) mit den Schenkel integral ausgebildet ist.

5. Abbildungsvorrichtung nach einem der vorhergehenden Ansprüche 1 bis 4, insbesondere nach Anspruch 1, **dadurch gekennzeichnet, dass** die schichtartige Leiterplatte (3) in der Öffnung (12) gebogen ist, ein an der schichtartigen Leiterplatte (3) angebrachtes peripheres Schaltungselement (27) so angeordnet ist, dass es einer gegenüberliegenden Seite der Lichtaufnahmeebene (2) des Abbildungselements (1) zugewandt ist, und das periphere Schaltungselement (27) in der Öffnung (12) aufgenommen ist.

6. Abbildungsvorrichtung nach einem der vorhergehenden Ansprüche 1 bis 5, **dadurch gekennzeichnet, dass** die Öffnung (12) mit einem Dichtungselement (26) abgedichtet ist.

7. Abbildungsvorrichtung nach einem der vorhergehenden Ansprüche 1 bis 6, **dadurch gekennzeichnet, dass** Bereiche (39), die mit einer Halteeinrichtung (35) in Berührung kommen, die zum Zeitpunkt der Anbringung der Abbildungsvorrichtung an einer elektronischen Einrichtung als eine Befestigungseinrichtung dient, an vier Ecken des Stützelements (11) angeordnet sind.

## Revendications

1. Dispositif d'imagerie, comprenant :
- un élément d'imagerie (1) présentant un plan de réception de lumière (2) ;
- un cadre (5) entourant les côtés périphériques dudit élément d'imagerie (1) et fixant ledit élément d'imagerie (1) ;
- une lentille de formation d'image (7) pour former une image sur ledit plan de réception de lumière (2) :
- un tube d'objectif (8) pour supporter ladite lentille de formation d'image (7);
- un élément de support (11) dans lequel ledit tube d'objectif (8) est monté et comportant des pieds (9) formant une ouverture (12) destinée à accueillir ledit cadre (5) et ledit élément d'imagerie (1) ;
- des saillies (6) formées à l'extérieur dudit cadre (5) dans la direction de sa largeur ; et
- des évidements (13) définis par une partie découpée desdits pieds (9) dudit élément de support (11), dans lesquels lesdites saillies (6) sont insérées et ajustées ;
**caractérisé par** :
- une plaquette de circuits en forme de film (3) sur laquelle un motif de câblage est formé, dans laquelle un trou traversant (4) est prévu pour exposer le plan de réception de lumière (2) d'un élément d'imagerie (1) ;
- la plaquette de circuits en forme de film (3) est positionnée sur le cadre (5) avec le trou traversant (4) aligné avec le plan de réception de lumière (2) de l'élément d'imagerie (1), et est logée à l'intérieur de l'ouverture (12) de l'élément de support (11) ;
- une deuxième partie découpée (17) est formée dans un des pieds (9) de l'élément de support (11) qui ne comporte pas d'évidement (13), de telle sorte que la plaquette de circuits en forme de film (3) puisse s'étendre depuis l'ouverture (12) à travers la découpe (17) sans être pliée ; et
- une saillie (19) orientée vers le bas à partir de l'élément de support (11) en direction de la plaquette de circuits en forme de film (3) et positionnée à l'intérieur de la deuxième découpe (17), et un trou (20) prévu sur ladite plaquette de circuits en forme de film (3) dans lequel ladite saillie (19) est insérée.

2. Dispositif d'imagerie selon la revendication 1, **caractérisé en ce qu'**un élément de renforcement (21) est monté sur la périphérie du trou de la plaquette de circuits en forme de film (3).

3. Dispositif d'imagerie selon l'une quelconque des revendications précédentes 1 et 2, **caractérisé en ce qu'**un adhésif est appliqué sur la périphérie du trou traversant (4) du substrat en forme de film (3), et ladite plaquette de circuits en forme de film est fixée à l'élément de support (11) formant les pieds (9) à l'aide dudit adhésif.

4. Dispositif d'imagerie selon l'une quelconque des revendications précédentes 1 à 3, **caractérisé en ce qu'**une nervure (22, 23) s'étendant en direction du tube d'objectif est formée d'un seul tenant avec les pieds.

5. Dispositif d'imagerie selon l'une quelconque des revendications précédentes 1 à 4, en particulier la revendication 1, **caractérisé en ce que** ladite plaquette de circuits en forme de film (3) est courbée dans l'ouverture (12), un élément de circuit périphérique (27) monté sur ladite plaquette de circuits en forme de film (3) est agencée face à un côté opposé du plan de réception de lumière (2) de l'élément d'imagerie (1), et ledit élément de circuit périphérique (27) est logé dans ladite ouverture (12).

6. Dispositif d'imagerie selon l'une quelconque des revendications précédentes 1 à 5, **caractérisé en ce que** l'ouverture (12) est scellée à l'aide d'un élément d'étanchéité (26).

7. Dispositif d'imagerie selon l'une quelconque des revendications précédentes 1 à 6, **caractérisé en ce que** des parties (39) entrant en contact avec un support (35) servant de moyen de fixation au moment du montage du dispositif d'imagerie sur un équipement électronique sont situées à quatre coins de l'élément de support (11).
